Europäisches Patentamt

European Patent Office

Office européen des brevets

(11) Publication number: **0 133 667**
**A2**

## (12) EUROPEAN PATENT APPLICATION

(21) Application number: **84108811.5**

(22) Date of filing: **25.07.84**

(51) Int. Cl.⁴: **H 01 L 29/60**

(30) Priority: **12.08.83 US 522890**

(43) Date of publication of application:
**06.03.85 Bulletin 85/10**

(84) Designated Contracting States:
**AT DE FR GB IT NL SE**

(71) Applicant: **AMERICAN MICROSYSTEMS,
INCORPORATED
3800 Homestead Road
Santa Clara, CA 95051(US)**

(72) Inventor: **Maltiel, Ron
164 King Street
Redwood City Calif. 94062(US)**

(74) Representative: **Schmidt-Evers, Jürgen, Dipl.-Ing. et al,
Patentanwälte Dipl.-Ing. H. Mitscherlich Dipl.-Ing. K.
Gunschmann Dipl.-Ing. Dr.rer.nat. W. Körber Dipl.-Ing. J.
Schmidt-Evers Dipl.-Ing. W. Melzer Steinsdorfstrasse 10
D-8000 München 22(DE)**

(54) **High coupling ratio dense electrically erasable programmable read-only memory.**

(57) A unique EEPROM cell is fabricated which is significantly different in construction than prior art EEPROMS, but which is capable of being fabricated using well known semiconductor processing techniques. In one embodiment, the EEPROM cell (10) includes not only a source region (18-2), a channel region (18-4), and a drain region 18-3) located within a semiconductor substrate (11), but also a separate and distinct programming region (18-1). A tunnelling dielectric (20), an oxide, rather than being formed over the drain region (18-3), is located over the tunnelling region (20), and a floating gate (21) extends not only over the channel region (18-4) and the drain region (18-3), but over the source region (18-2) and the tunnelling region (20) as well. The EEPROM memory cell (10) constructed in this manner allows greater efficiency than prior art EEPROMS and greater control over the capacitances of the cell, which determines cell efficiency.

FIG. 3

EP 0 133 667 A2

HIGH COUPLING RATIO DENSE ELECTRICALLY
ERASABLE PROGRAMMABLE READ-ONLY MEMORY

Ron Maltiel

BACKGROUND OF THE INVENTION

Field of the Invention

This invention relates to semiconductor circuits and structures and in particular to electrically erasable programmable read-only memories (EEPROMs).

Description of the Prior Art

Electronic memory devices are well known in the prior art. Read-only memories (ROMs) provide a plurality of binary digits (bits) of information. ROMs are programmed to store this information during their fabrication process, and thus, once fabricated, their program states are forever fixed. Programmable read-only memories (PROMs) are electrically programmed after fabrication is complete, thus allowing a large number of unprogrammed PROM devices to be fabricated, and a relatively short turn around time for programming these fabricated devices. Erasable PROMs (EPROMs) are similar to PROMs, with the exception that the data stored therein may be erased, typically by exposure to ultraviolet light (UV). EPROMs, when erased, lose all bits of information stored therein, and this is often referred as "bulk erasure". The most recent generation of memories is the electrically erasable programmable read-only memories (EEPROMs), which allow contents of a programmed EEPROM to be electrically erased, thereby allowing reprogramming. Because the entire circuit is not exposed to ultraviolet light in order to cause erasure of information stored therein, if properly designed, an EEPROM may allow erasure of a single word, or even a single bit, while retaining all other programmed information unchanged.

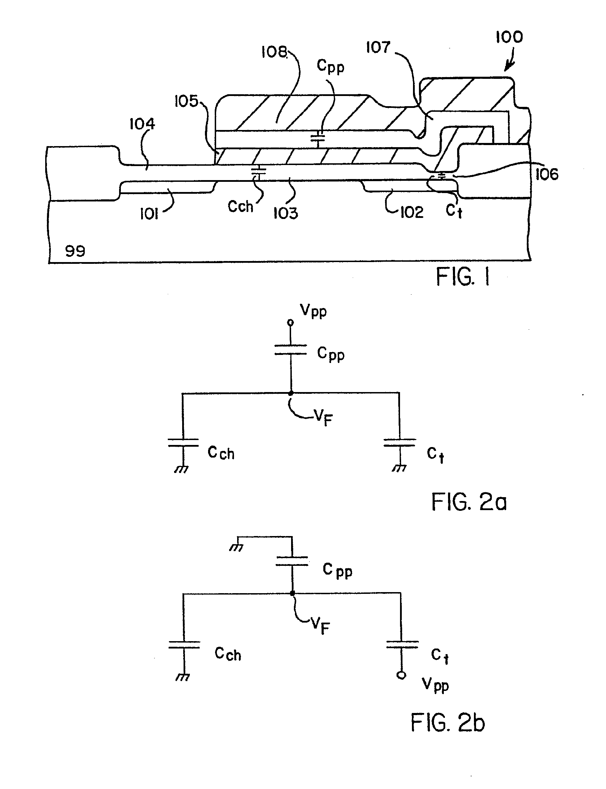

A typical prior art EEPROM is described by Johnson, et al., in an article entitled "16-K EE-PROM Relies On Tunneling For Byte-Erasable Program Storage, Electronics, February 28, 1980, pages 113-117. A typical prior art EEPROM a memory cell is shown in Figure 1 and includes a transistor 100 having source 101 and drain 102 formed in a silicon substrate 99 and having a channel region 103 formed therebetween. A layer of gate insulation 104 electrically insulates a floating gate 105 formed above the channel 103, and extending over the drain 102. A very thin tunnel oxide region 106 electrically insulates a small portion of the floating gate 105 from the drain 102. This prior art structure further includes a control gate 108, and a layer of insulation 107 formed between the floating gate 105 and the control gate 108.

Also shown in Figure 1 are various capacitances formed in the cell. For example, $C_{ch}$ is the capacitance formed between floating gate 105 and channel region 103, capacitance $C_{pp}$ is the capacitance formed between control gate 108 and floating gate 105, and capacitance $C_t$ is the capacitance formed between floating gate 105 and drain 102.

To store a logical one in such a prior art EEPROM memory cell, typically no charge is stored on its floating gate 105. When no charge is stored on the floating gate 105, the transistor 100 turns on when a read voltage Vr which is greater than the control gate threshold voltage Vt (i.e., the voltage required to be applied to the control gate 108 to cause the transistor to turn on, typically 2.0 volts) of a cell storing a logical one, is applied to its control gate. Conversely, in order to store a logical zero in memory cell 100, electrons are injected into the floating gate 105 thereby to provide a negative voltage on the floating gate, and thus increasing the control gate threshold voltage. This injection of electrons on the floating gate is accomplished for example, by Fowler-Nordheim tunneling. One technique for this electron tunneling is to place a high voltage (typically 10 to 20 volts) on the control gate 108, and grounding the drain 102, source 101 and substrate 99. This causes electrons to tunnel from the drain region 102 through the tunneling oxide 106 to the floating gate 105. During this programming of the cell to a logical zero, sufficient electrons are stored within the floating gate 105 to increase the control gate threshold voltage Vt of the memory cell (typically to greater than 5 volts) such that the cell will not turn on in response to a read voltage Vr placed on its control gate.

In order to erase a memory cell or, in other words, to change the state of a memory cell from a logical zero to a logical one, the floating gate 105 is discharged. This is accomplished, for example, by placing the control gate 108 at ground, a high positive voltage on the drain 102, (typically +20 volts) disconnecting the source 101 (i.e., the source is "floating"), and connecting the substrate 99 to ground. This causes electrons to flow from the floating gate 105 through the tunelling oxide 106 to the drain 102, thereby discharging the floating gate 105, decreasing the control gate threshold voltage, and storing a logical zero in the memory cell 100.

Shown in Figure 2a is the connection of the various capacitances of cell 100 of Figure 1 during the programming of cell 100 to store logical zero. During programming, the control gate 108 is connected to a high programming voltage $V_{pp}$, and the drain 102, source 101 and substrate 99 (and thus the channel region 103) are grounded. In a case where the channel is not inverted and neglecting contribution due to the charge on floating gate 105 (which provides an approximation which is suitable for the purposes of discussion here) the voltage $V_F$ between the floating gate 105 and the drain 102 may be expressed as a fraction of the programming voltage $V_{pp}$ as follows:

$$V_F = V_{pp}(C_{pp})/(C_{pp}+C_t+C_{ch}) \tag{1}$$

or $V_F = AV_{pp}$ where $\tag{2}$

A is the programming efficiency and

$$A = (C_{pp})/(C_{pp}+C_t+C_{ch}) \tag{3}$$

Similarly, during erasure, with the control gate 108, substrate 99 (and thus channel region 103) connected to ground, and a high positive voltage $V_{pp}$ placed on drain 102, the capacitances of cell 100 are connected as shown in Figure 2b. Here again, neglecting contribution due to the charge on the floating gate (which provides an approximation which is suitable for the purposes of this discussion), the voltage $V_F$ between the floating gate 105 and the drain 102 may be expressed as a fraction of the programming voltage $V_{pp}$ as follows:

$$V_F = V_{pp}(C_{pp}+C_{ch})/(C_{pp}+C_{ch}+C_t) \tag{4}$$

or $V_F = BV_{pp}$ where $\tag{5}$

B is the erasing efficiency and

$$B = (C_{pp}+C_{ch})/(C_{pp}+C_{ch}+C_t) \tag{6}$$

The various capacitances cell 100 may be calculated utilizing the following equation:

$$C = \varepsilon A/t, \text{ where} \tag{7}$$

C        is the capacitance,

$\varepsilon$        is the dielectric constant (approximately $3.45 \times 10^{-13}$ for $SiO_2$),

A          is the plate area, and

t          is the dielectric thickness.

For typical prior art EEPROMS, the cell dimensions and thus capacitances are as shown in Table 1.

TABLE 1

| Symbol | Plate Dimensions (Microns$^2$) | Dielectric Thickness (Angstroms) | Capacitance (Farads) |
|---|---|---|---|
| $c_t$ | 2.25 | 100 | $7.8 \times 10^{-15}$ |
| $C_{ch}$ | 10.5 | 750 | $4.8 \times 10^{-15}$ |
| $C_{pp}$ | 115.0 | 800 | $49.6 \times 10^{-15}$ |

Thus, for a typical prior art EEPROM cell, the programming efficiency A (equation (3)) is approximately 79.8% and the erasing efficiency B (equation (6)) is approximately 87%.

The speed of charging the floating gate (i.e., programming the cell) and discharging the floating gate (i.e., erasing the cell) is determined by the magnitude of the electric field across the tunneling dielectric 106. This in turn is dependent on the magnitude of the voltgage $V_{pp}$ which is applied between the control gate 108 and the tunneling region (i.e., drain 102) within the substrate beneath the tunneling dielectric 106, as well as the coupling ratio of the cell. The coupling ratio defines what portion of the applied voltage $V_{pp}$ appears across the tunneling dielectric 106 between the floating gate 105 and the tunneling region (i.e., drain) 102.

Since it it desirable to provide an EEPROM cell having high programming and erasing speeds, it is desirable to construct the cell such that the programming and erasing coupling efficiencies are as close to unity as possible. To accomplish this, the value of $C_t$ should be made as small as possible, and the value of capacitances $C_{ch}$ and

$C_{pp}$ should be as large as possible. There are practical limits to the minimum plate size of capacitance $C_t$; using technology capable of producing 3 micron line widths, a $C_t$ plate size of approximately 2.25 x 1.0 microns is perhaps the minimum possible. Furthermore, the thickness of tunneling dielectric 106 must be made sufficiently small to allow efficient tunneling to occur between floating gate 105 and source 102. The capacitances $C_{ch}$ and $C_{pp}$ can be increased without limit thus aiding the efficiency of the cell, however maintaining a small cell size is critical. Thus, there is a tradeoff to be made between reduced cell size versus increased programming and erasing efficiencies. Furthermore, increasing the programming and erasing voltage $V_{pp}$ will increase the speed of programming and erasing the EEPROM cell. However, it is also highly desirable to minimize the programmable voltage $V_{pp}$, thereby to prevent circuit failure due to undesired voltage breakdowns, as well as to allow the EEPROM cells to be used in circuits which do not need to provide a rather high voltage as $V_{pp}$.

U.S. Patent No. 4,361,847 issued November 30, 1982, to Harari discloses a unique electrically erasable, programmable read-only memory cell wherein, in contrast to other prior art structures, the tunneling dielectric is formed over a portion of the channel region and the floating gate extends over the drain diffusion and only a portion of the channel region. Harari's structure alo requires that the capacitance between the source and the floating gate be held to a minimum. Other prior art EEPROM devices are described in U. S. Patents No. 4,342,099; 4,267,632; and 4,115,914 which, together with the previously mentioned U.S. Patent No. 4,361,847, are hereby incorporated by reference.

## SUMMARY

This invention allows the improvement of the efficiency of an EEPROM by forming a unique EEPROM cell which is significantly different in construction than prior art EEPROMs, but which is capable of being fabricated using well known semiconductor processing techniques. In accordance with one embodiment of my invention, the EEPROM cell includes not only a source, a channel, and a drain region located within a semiconductor substrate, but also a separate and distinct programming diffusion. The tunneling oxide, rather than being formed over the drain region, is located over the tunneling region, and the floating gate extends not only over the source, the channel and the drain, but over the tunneling region as well. In this manner, a unique EEPROM memory cell constructed in accordance with my invention is formed which allows greater efficiency than prior art EEPROMs and greater control over the capacitances of the cell, which determines cell efficiency.

## BRIEF DESCRIPTION OF THE DRAWINGS

Figure 1 is a cross-sectional view of a typical prior art EEPROM cell;

Figure 2a is a schematic diagram depicting the interrelationships between the capacitances of the prior art EEPROM cell of Figure 1 during programming;

Figure 2b is a schematic diagram depicting the interrelationships between the capacitances of the prior art EEPROM cell of Figure 1 during erasure;

Figure 3 is a cross-sectional view of an EEPROM cell constructed in accordance with one embodiment of my invention;

Figure 4a is a schematic diagram depicting the interrelationships between the capacitances of the EEPROM cell of Figure 3 during programming;

FIgure 4b is a schematic diagram depicting the interrelationships of the capacitances of the EEPROM cell of Figure 3 during erasure; and

Figures 5a-5h are cross-sectional views depicting the fabrication of an EEPROM cell constructed in accordance with one embodiment of this invention.

DETAILED DESCRIPTION

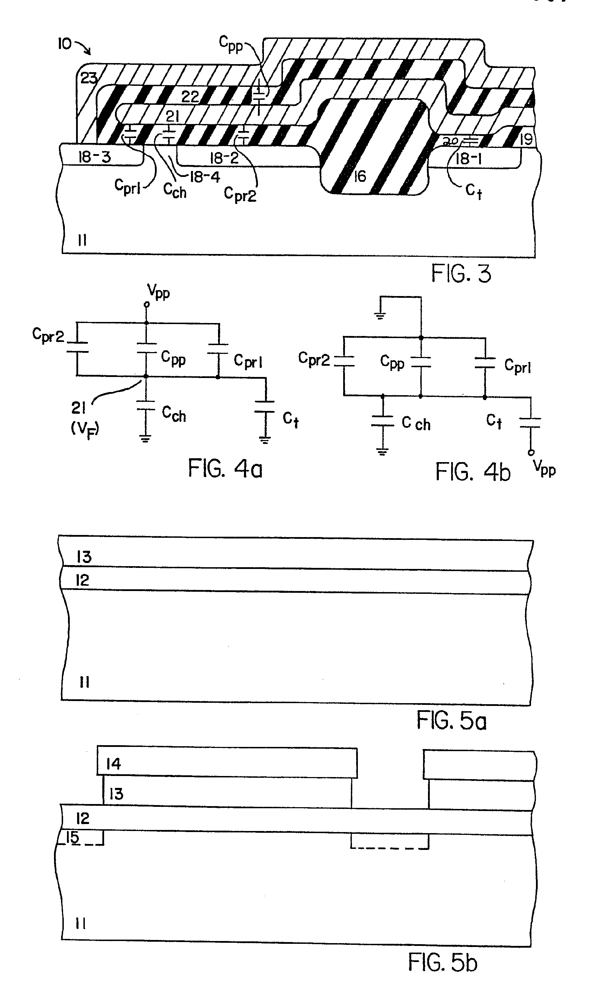

Figure 3 is a cross-sectional view of one embodiment of an EEPROM cell constructed in accordance with this invention. For sake of example, the cell of Figure 3 will be described as being fabricated in a P type silicon substrate, having N type diffused regions formed therein, and utilizing polycrystalline silicon interconnects and gates. Naturally, other embodiments of my invention utilize different conductivity types and interconnects made of materials other than polycrystalline silicon, such as aluminum, alloys of aluminum, refractory metals, and alloys of refractory metals.

As shown in Figure 3, within P-type substrate 11 is formed N-type drain region 18-3, N-type source region 18-2, and a unique N-type programming region 18-1 which is separated from source region 18-2 by thick field oxide 16. A channel region 18-4 is formed within substrate 11 between drain region 18-3 and source region 18-2. A gate dielectric (e.g., oxide) 19 is formed on the surface of the substrate 11 over drain region 18-3, source region 18-2, the channel region 18-4, and a portion of programming region 18-1. Above the remaining portion of programming region 18-1 is formed thin tunneling dielectric 20, which allows electrons to flow (by tunneling) between the floating gate 21 and programming region 18-1 during programming and erasure of cell 10. Floating gate 21 is formed above drain 18-3, channel 18-4, source 18-2, and programming region 18-1. Formed on the sides and top of floating gate 21 is dielectric layer 22 (such as oxide), above which is formed control gate 23, which is connected to drain 18-3, as shown. If desired, the floating gate 21 need not be electrically connected to drain 18-3 if other means of applying to drain 18-3 the voltages necessary to program and erase the cell are provided. Those of ordinary skill in the art will appreciate that gate oxide 19 need not be formed over any portion of tunneling region 18-1; the formation of thin tunneling oxide 20 and the insulation of floating gate 21 from programming region 18-1 is of importance. Furthermore, tunneling dielectric may be formed of, for example, silicon nitride, silicon dioxide, or a "sandwich" formed of silicon dioxide and silicon nitride. Also, if desired, control gate 23 need not be formed, and the data (i.e., logical one or zero) stored in the memory cell is determined by whether current flows between the source 18-2 and the drain 18-3 as a result of the voltages applied thereto as well as the charge stored on floating gate 21.

Also as shown in Figure 3, a capacitance $C_{pr1}$ is formed between floating gate 21 and drain 18-3, a capacitance $C_{ch}$ is formed between floating gate 21 and channel 18-4, a capacitance $C_{pr2}$ is formed between floating gate 21 and source 18-2, a capacitance $C_t$ is formed between floating gate 21 and programming region 18-1, and a capacitance $C_{pp}$ is formed between polycrystalline silicon control gate 23 and polycrystalline silicon floating gate 21.

In order to store a logical one in cell 10, substrate 11 and tunneling region 18-1 are connected to ground, and control gate 23 (and thus drain 18-3) and source 18-2 are connected to a highly positive programming voltage $V_{pp}$ (typically 20 volts). This causes electrons to tunnel through tunneling oxide 20 from tunneling region 18-1 to floating gate 21, thus charging floating gate 21 to a negative potential. This negative potential on floating gate 21 causes the control gate threshold voltage to be increased, thus indicating that cell 10 stores a logical zero. In order to erase cell 10, electrons are removed from floating gate 21 in order to lower the control gate threshold voltage and thus store a logical one in cell 10. This is accomplished by connecting control gate 23, and thus drain 18-3, to ground, grounding substrate 11 and source 18-2, and connecting a relatively high programming voltage $V_{pp}$ (typically 20 volts) to tunneling region 18-1. This causes electrons to tunnel through tunneling oxide 20 from floating gate 21 to tunneling region 18-1, thereby removing the negative charge on floating gate 21 and discharging floating gate 21. This causes the control gate threshold voltage of memory cell 10 to be decreased over that of a cell which has been programmed to store a logical zero, and less than the read voltage Vr.

Shown in Figure 4a is the connection of the various capacitances of cell 10 of Figure 3 during the programming of cell 10 to store a logical zero. During programming, the substrate 11 (and thus the channel region 18-4) and tunneling area 18-1 are connected to ground, and control gate 23, drain 18-3, and source 18-2 connected to a positive programming voltage $V_{pp}$. In a case where the channel is not inverted and neglecting contribution due to the charge on floating gate 21 (which provides an approximation which is suitable for the purposes of discussion here) the voltage $V_F$ between floating gate 21 and tunneling region 18-1 may be expressed as a fraction of the programming voltage $V_{pp}$ as follows:

$$V_F = V_{pp}(C_{pp}+C_{pp1}+C_{pp2})/(C_{pp}+C_{pr1}+C_{pr2}+C_{ch}+C_t) \quad (8)$$

$$\text{or } V_F = \alpha V_{pp}, \text{ where} \quad (9)$$
$$\alpha \text{ is the programming efficiency and}$$

$$\alpha = (C_{pp}+C_{pp1}+C_{pp2})/(C_{pp}+C_{pr1}+C_{pr2}+C_{ch}+C_t) \quad (10)$$

Thus, because the EEPROM cell constructed in accordance with my invention included capacitances $C_{pp1}$ and $C_{pp2}$ as indicated by the above equations, the programming efficiency $\alpha$ of an EEPROM cell construction in accordance with my invention is improved as compared with that of a prior art EEPROM having similar plate dimensions and cell size.

Similarly, during erasure (as shown in Figure 4b), with substrate 11, channel 18-4, control gate 23, drain 18-3, and source 18-2 connected to ground, and tunneling region 18-1 connected to programming voltage $V_{pp}$, neglecting contribution due to the charge on floating gate 21 (which provides an approximation which is suitable for purposes of this discussion) the voltage $V_F$ between the floating gate 21 and the programming region 18-1 may be expressed as a fraction of the programming voltage $V_{pp}$ as follows:

$$V_F = V_{pp}(C_{ch}+C_{pr1}+C_{pr2}+C_{pp})/(C_{ch}+C_{pr1}+C_{pr2}+C_{pp}+C_t \quad (11)$$

$$\text{or } V_F = \beta V_{pp}, \text{ where} \quad (12)$$
$$\beta \text{ is the erasing efficiency and}$$

$$\beta = (C_{ch}+C_{pr1}+C_{pr2}+C_{pp})/(C_{ch}+C_{pr1}+C_{pr2}+C_{pp}+C_t) \quad (13)$$

Thus, because the EEPROM cell constructed in accordance with my invention included capacitances $C_{pp1}$ and $C_{pp2}$ as indicated by the above equations, the erasing efficiency $\beta$ of an EEPROM cell construction in accordance with my invention is improved as compared with that of a prior art EEPROM having similar plate dimensions and cell size.

The capacitor plate areas, dielectric thicknesses, and resulting capacitances of one EEPROM cell constructed in accordance with one embodiment of my invention are shown in Table 2.

TABLE 2

| Symbol | Plate Dimensions (Microns$^2$) | Dielectric Thicknes (Angstroms) | Capacitance (Farads) |
|---|---|---|---|
| $C_t$ | 2.25 | 100 | $6.9 \times 10^{-15}$ |
| $C_{ch}$ | 10.5 | 750 | $4.1 \times 10^{-15}$ |
| $C_{pr1}$ | 70.0 | 750 | $32.2 \times 10^{-15}$ |
| $C_{pr2}$ | 48.0 | 750 | $22.2 \times 10^{-15}$ |
| $C_{pp}$ | 146.0 | 800 | $63.1 \times 10^{-15}$ |

Thus, for an EEPROM constructed in accordance with one embodiment of my invention, the programming efficiency $\alpha$ (equation (10)) is approximately 90% and the erasing efficiency $\beta$ (equation (13)) is approximately 95%. Of importance, the test structure referred to in Table 2 is slightly larger than the prior art EEPROM cell referred to in Table 1. However, the principles of this invention can easily be applied by one of ordinary skill in the art to fabricate EEPROM cells having the same or smaller cell size than prior art EEPROM cells, while still providing the increased programming and erasing efficiencies made possible by my invention.

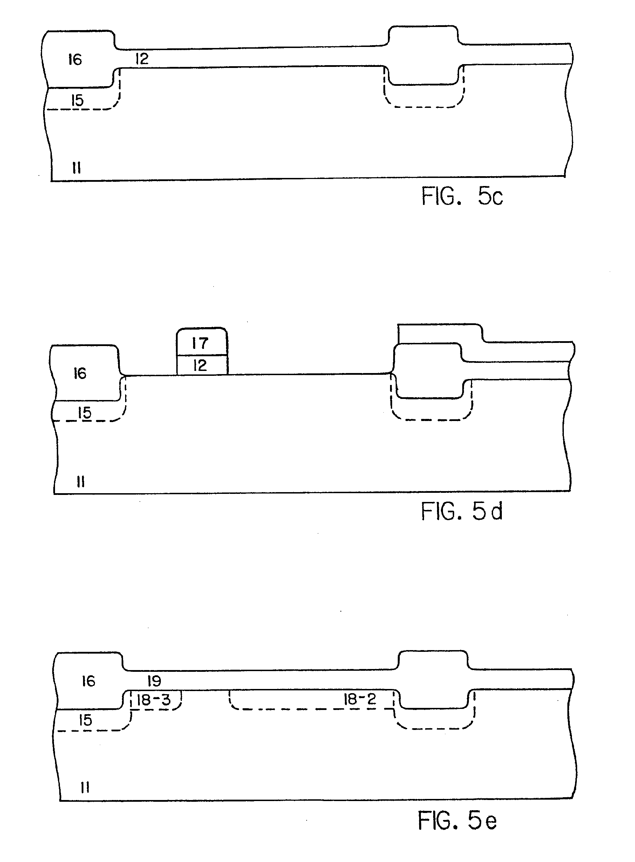

One process for fabricating a device in accordance with one embodiment of my invention is depicted in the cross-sectional views of Figures 5a through 5h. As shown in Figure 4a, a P-type substrate 11 having crystal orientation <100> and having a resistivity within the range of approximately 30 to 66 ohm-cm is used. A layer of base oxidation 12 is formed to a thickness within the range of

approximately 700 to 800Å by, for example, oxidation in dry oxygen plus approximately 3% HCL for approximately 55 minutes at approximately 1,000°C. Naturally, suitable "ramp up" and "ramp down" temperatures in suitable atmospheres are utilized to prevent excessive thermal shock to the wafer undergoing this base oxidation step. These ramp up and ramp down steps, as well as other ramp up and ramp down steps used in conjunction with later oxidations described in the specification will not be described in detail as they are readily apparent to those of ordinary skill in the art.

After the formation of base oxide 12, a layer of silicon nitride 13 is formed to a thickness within the range of approximately 1400 to 1600Å by, for example, low pressure chemical vapor deposition (LPCVD) as described, for example, in an article by Rosler entitled "Low Pressure CVD Production Processes For Poly, Nitride, and Oxide", Solid-State Technology, April 1977, pages 63-70, which is hereby incorporated by reference.

As shown in Figure 5b, a layer of photoresist 14 is formed in a well known manner and patterned utilizing suitable photolithographic techniques well known to those of ordinary skill in the art in order to define those regions in which field oxide is to be formed. Nitride layer 13 is then patterned, for example, utilizing a $CF_4$ plasma, in order to expose those portions of base oxide 12 where field oxide is to be formed. If desired, a field implant is performed in order to increase the field inversion voltage. This is performed, for example, by the ion implantation of boron to a dosage of approximately 3.0 X $10^{13}$ ions/cm$^2$ at an energy level of approximately 70 KEV. The implanted boron is indicated by the dashed lines labeled 15 in Figure 5b.

The remainder of photoresist 14 is then removed utilizing suitable well known techniques. The portions of base oxide 12 exposed by nitride layer 13 is then removed, for example, by etching with buffered HF.

As shown in Figure 5c, field oxide 16 is then grown in those regions of the substrate 11 exposed by nitride layer 13 to a thickness within the range of approximately 12,000 to 14,000Å by, for example, oxidation in wet $O_2$ at approximately 900°C for approximately 840 minutes. The remaining portions of nitride layer 13 are then removed, for example, by etching with a $CF_4$ plasma, thereby providing the structure shown in Figure 5c.

As shown in Figure 5d, a layer of photoresist 17 is formed and patterned, utilizing suitable well known photolithographic techniques, in order to protect the base oxide 12 overlying the channel regions of the to be formed EEPROM cell. Undesired portions of base oxide are then removed, for example, by etching with buffered HF. Source and drain regions 18-2 and 18-3, respectively, are then formed, for example by the implantation of arsenic ions to a dosage of $8.0 \times 10^{15}$ ions/cm$^2$ at an energy level of approximately 50 KEV.

Photoresist 17 is then removed, and the remaining portions of base oxide 12 are removed, for example, using buffered HF. Gate oxide 19 is then formed as shown in Figure 5f, for example, by oxidation in dry oxygen containing approximately 3% HCL for approximately 55 minutes at approximately 1000°C. This results in gate oxide 19 having a thickness within the range of approximately 700 to 800 Å.

A layer of photoresist (not shown) is then applied to the surface of the wafer and patterned to expose that portion of the wafer upon which is to be formed the tunneling region 18-1 (Fig. 3). Gate oxide 19 is then removed in this area, for example, by etching with buffered HF.

Tunneling region 18-1 is then formed, for example, by the implantation of arsenic to a dosage of approximately $1 \times 10^{14}$ ions/cm$^2$ at energy of approximately 100 KEV. The photoresist is then removed, and the tunneling oxide 20 is formed, for example, to a thickness of approximately 100Å. Tunneling oxide 20 is formed, for example, by thermal oxidation by transferring the wafer from an ambient atmosphere to a nitrogen atmosphere containing approximately 1% oxygen at a temperature of approximate 900°C during a 10 minutes "push" cycle, holding the wafer in the 1% oxygen/99% nitrogen atmosphere at approximately 900°C, for approximately 10 minutes, changing the atmosphere to pure oxygen at approximately 900°C for a period of approximately five minutes, changing the atmosphere to nitrogen containing approximately 9% HCL at approximately 900°C for approximately 10 minutes, changing the atmosphere to pure oxygen at approximately 900°C for approximately 10 minutes, changing the atmosphere to pure nitrogen at approximately 900°C for approximately 10 minutes, and removing the wafer from the pure nitrogen atmosphere to an ambient atmosphere during a 10 minute "pull" cycle.

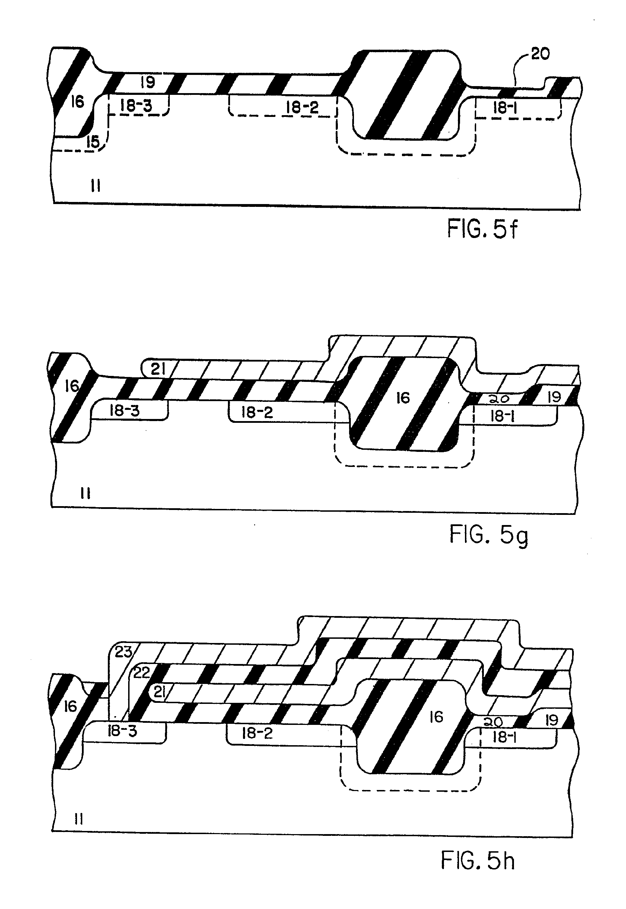

As shown in Figure 5g, a layer of polycrystalline silicon 21, which will serve as the floating gate of the EEPROM device, is formed to a thickness within the range of approximately 3900 to 4600Å using, for example, low pressure chemical vapor deposition. A layer of photoresist (not shown) is then formed in order to expose those portions of polycrystalline silicon layer 21 which are to be removed and to protect those portions of polycrystalline silicon layer 21 which are to remain to form floating gate 21. Exposed portions of polycrystalline silicon layer 21 are then removed, for example, using a CF$_4$ plasma. The photoresist is then removed, and the polycrystalline silicon is then doped, for example, with POCl$_3$, in order to have a V/I characteristic within the range of approximately 2.5 to 3.5. Of importance, Oxide layer 22, shown in Figure 5g, is then formed to a thickness within the range of approximately 700 to 800Å by, for example, oxidizing polycrystalline silicon layer 21 for approximately 30 minutes in oxygen at 1100°C. As shown in Figure 5h, a layer of polycrystalline silicon 22 is then formed to a thickness of approximately 3800 to 4500Å by, for example, low pressure chemical vapor deposition. Polycrystalline silicon layer 22 is then doped with, for example, $POCl_3$, to have a V/I characteristic within the range of approximately 2.5 to 3.5. Polycrystalline silicon layer 22 which will serve as the control gate of the EEPROM cells, is then defined utilizing well known photolithographic techniques and patterned, for example, utilizing a $CF_4$ plasma.

If desired, additional processing steps are used to form additional insulation layers on the surface of the device, and if desired, additional layers of electrical interconnects, for example, aluminum. These final processing steps are well known to those of ordinary skill in the art and thus will not be described here.

Furthermore, the particular embodiments described in this specification are meant to serve by way of example and are not meant in any sense to be limitations on the scope of my invention. Numerous other embodiments of my invention will become readily apparent to those of ordinary skill in the art in light of the teachings of this specification.

CLAIMS
======

1. An electrically erasable programmable read only memory comprising a semiconductor substrate (11) of a first conductivity type, a source region (18-2) being of a second conductivity type opposite said first conductivity type, a drain region (18-3) formed within said substrate (11), said drain region (18-3) being of said second conductivity type and spaced apart from said source region (18-2), a channel region (18-4) located within said substrate (11) between said source region (18-2) and said drain region (18-3), said electrically erasable programmable read-only memory (10) characterized by:

a programming region (18-1) formed in said substrate (11), said programming region (18-1) being located apart from said source region (18-2) and said drain region (18-3);

a layer of gate dielectric (19) formed on the surface of said substrate (11) above said source region (18-2), said drain region (18-3), and said channel region (18-4);

a tunnelling dielectric (20) formed on the surface of said substrate (11) above at least a portion of said programming region (18-1), and

a floating gate region (21) formed above at least said channel region (18-4) and a portion of said programming region (18-1) and separated from said channel region (18-4) by said gate dielectric (19) and separated from said programming region (18-1) by said tunnelling dielectric (20).

2. The electrically erasable programmable read only memory according to claim 1 further characterized by:

a floating gate dielectric layer (22) formed above said floating gate (21); and

a control gate (23) formed above said floating gate (21) and insulated therefrom by said floating gate dielectric layer (22).

3. The electrically erasable programmable read only memory according to claim 1 or 2, characterized in that said programming region (18-1) is of said second conductivity type.

4. The electrically erasable programmable read only memory according to any one of claims 1 - 3, characterized in that said programming region (18-1) is separated from said source region (18-2) by a layer of field oxide (16).

5. The electrically erasable programmable read only memory according to any one of claims 2 - 4, characterized in that said floating gate (21) comprises polycrystalline silicon.

6. The electrically erasable programmable read only memory according to any one of claims 2 - 5, characterized in that said control gate (23) comprises material selected from the group of materials consisting of polycrystalline silicon, doped polycrystalline silicon, aluminum, alloys of aluminum, refractory metals, and alloys of refractory metals.

7. The electrically erasable programmable read only memory according to any one of claims 1 - 6 characterized in that said gate dielectric (19) comprises an oxide of silicon.

8. The electrically erasable programmable read only memory according to claim 7 characterized in that said gate dielectric layer (19) has a thickness within the range of approximately less than 1000Å.

9. The electrically erasable programmable read only memory according to any one of claims 1 - 8, characterized in that said tunnelling dielectric (20) comprises an oxide of silicon.

10. The electrically erasable programmable read only memory according to claim 9, characterized in that said tunnelling dielectric (20) has a thickness within the range of approximately less than 250Å.

11. The electrically erasable programmable read only memory according to any one of claims 1 - 8, characterized in that said tunnelling dielectric (20) comprises a first layer of silicon dioxide and a second layer of silicon nitride.

12. The electrically erasable programmable read only memory according to any one of claims 2 - 11, characterized in that said control gate (23) ist connected to said drain region (18-3).

13. A method for programming an electrically erasable programmable read only memory having a source, a channel, a drain, and a programming region formed within a semiconductor substrate, a floating gate separated from said source, channel, and drain region by a gate oxide, and separated from said programming region by a tunnelling dielectric, and a control gate, said method characterized by the steps of:

connecting said programming region to said first selected voltage;

connecting said control gate to a second selected voltage;

connecting said source to said second selected voltage; and

connecting said drain to said second selected voltage, whereby electrons tunnel between said programming region and said floating gate through said tunnelling dielectric.

14. A method for forming an electrically erasable programmable read only memory in a semiconductor substrate comprising the steps of forming on the surface of said substrate thick field oxide regions in those areas where active regions are not to be formed, forming in said substrate a first region of a second conductivity type opposite said first conductivity type which is to serve as a drain region, and a second region of said second conductivity type to serve as a source region, wherein the portion of said substrate located between said source and said drain region will serve as a channel region, said method characterized by the steps of:

forming a tunnelling region within said substrate and separated from said source, drain, and channel regions; and

forming a floating gate electrode above and insulated from said drain, channel, source, and tunnelling regions.

15. The method according to claim 14, further characterized by the step of forming a control gate electrode above and electrically insulated from said floating gate.

16. The method according to claim 14 or 15, characterized in that said tunnelling region is of said second conductivity type.

17. The method according to claim 14 or 15, characterized in that a thin tunnelling dielectric is formed between said tunnelling region in said floating gate electrode.

18. The method according to any one of claims 14 - 17, characterized in that said tunnelling region is separated from said source region by a thick field oxide region.

19. The method according to any one of claims 14 - 18, characterized in that said control gate is electrically connected to said drain region.

FIG. 1

FIG. 2a

FIG. 2b

FIG. 3

FIG. 4a

FIG. 4b

FIG. 5a

FIG. 5b

FIG. 5c

FIG. 5d

FIG. 5e

FIG. 5f

FIG. 5g

FIG. 5h